# EUROPEAN PATENT APPLICATION

(11) **EP 4 597 821 A1**
(43) Date of publication of application: **06.08.2025**
(21) Application number: 25150979.0
(22) Date of filing: 09.01.2025
(51) Int. Cl.: H02M 7/5387, H02M 7/00, H02M 1/44, H02K 11/33, H02K 9/19, H05K 7/20

(54) **POWER CONVERSION DEVICE**

(30) Priority: 31.01.2024 JP 2024013316
(71) Applicant: AISIN CORPORATION, Kariya, Aichi 448-8650 (JP)
(72) Inventor: TAKEMOTO, Keisuke, Kariya, 448-8650 (JP); MUTSUURA, Keita, Kariya, 448-8650 (JP); SUGIMOTO, Noriaki, Kariya, 448-8650 (JP)
(74) Representative: Kramer Barske Schmidtchen Patentanwälte PartG mbB

(57) **Abstract**

A power conversion device (8) includes: a housing (AH); a power conversion circuit (1) accommodated in the housing and configured to convert power; and a cooling plate (2) accommodated in the housing and configured to cool the power conversion circuit by using a cooling fluid. The power conversion circuit includes a high-voltage electronic component (14) through which high-voltage power flows and a low-voltage electronic component (15) through which low-voltage power having a voltage lower than a voltage of the high-voltage electronic component flows. A shield body (11) branching and protruding from the cooling plate is disposed between the high-voltage electronic component and the low-voltage electronic component in the power conversion circuit.

## Description

### TECHNICAL FIELD

This disclosure relates to a power conversion device.

### BACKGROUND DISCUSSION

JP 2014-131371A (Reference 1) discloses a DC-DC converter to be mounted on an automobile that obtains a drive force from an electric motor, the DC-DC converter including a first wall portion that separates a low-voltage circuit unit and a high-voltage circuit unit. Specifically, as shown in FIG. 12 of Reference 1, there is disclosed a configuration in which a first wall (120) is disposed between a first space (150) in which the high-voltage circuit unit is accommodated and a second space (151) in which the low-voltage circuit unit is accommodated.

It is conceivable to provide, in a vehicle that travels by using the drive force from the electric motor, a power conversion device that controls power supplied to the electric motor with respect to a housing that accommodates the electric motor, a reduction gear, and the like.

In the vehicle that travels by using the drive force from the electric motor, a charging circuit that performs transformation and rectification may be required in order to enable a battery that supplies power to the electric motor to be charged from commercial power supplied from the outside. In addition, in order to supply power to an in-vehicle air conditioner, display meters, and operate a car navigation system or the like, a DC-DC converter circuit that converts battery power into low-voltage power may be required. Therefore, it is also conceivable to configure a power conversion device by using the charging circuit, the DC-DC converter circuit, and the like as one package and to accommodate the power conversion device in the housing.

However, in the configuration in which the power conversion device having the above members configured as one package is accommodated in the housing in which the electric motor is accommodated, for example, there is a concern that noise from another power conversion circuit or heat from another circuit acts on the low-voltage DC-DC converter circuit, which leads to malfunction.

A need thus exists for a power conversion device in which a low-voltage circuit can appropriately operate even in an environment influenced by noise and heat.

### SUMMARY

A characteristic configuration of a power conversion device according to this disclosure includes: a housing; a power conversion circuit accommodated in the housing and configured to convert power; and a cooling plate accommodated in the housing and configured to cool the power conversion circuit by using a cooling fluid, in which the power conversion circuit includes a high-voltage electronic component through which high-voltage power flows and a low-voltage electronic component through which low-voltage power having a voltage lower than that of the high-voltage electronic component flows, and a shield body branching and protruding from the cooling plate is disposed between the high-voltage electronic component and the low-voltage electronic component in the power conversion circuit.

According to this configuration, since the shield body is disposed between the high-voltage electronic component and the low-voltage electronic component, a phenomenon in which heat and noise from the high-voltage electronic component act on the low-voltage electronic component is prevented. Therefore, a power conversion device in which a low-voltage circuit can appropriately operate even in an environment influenced by noise and heat is obtained.

### BRIEF DESCRIPTION OF THE DRAWINGS

The foregoing and additional features and characteristics of this disclosure will become more apparent from the following detailed description considered with the reference to the accompanying drawings, wherein:
FIG. 1 is a cross-sectional view showing a positional relationship among a shield body, a parallel shield portion, and an OBC substrate;
FIG. 2 is a plan view of the OBC substrate; and
FIG. 3 is a perspective view showing the positional relationship among the shield body, the parallel shield portion, and the OBC substrate.

### DETAILED DESCRIPTION

Hereinafter, a power conversion device according to an embodiment disclosed here will be described with reference to the drawings. The present embodiment is not limited to the following embodiment, and various modifications are possible without departing from the spirit and scope disclosed here.

### Basic Configuration

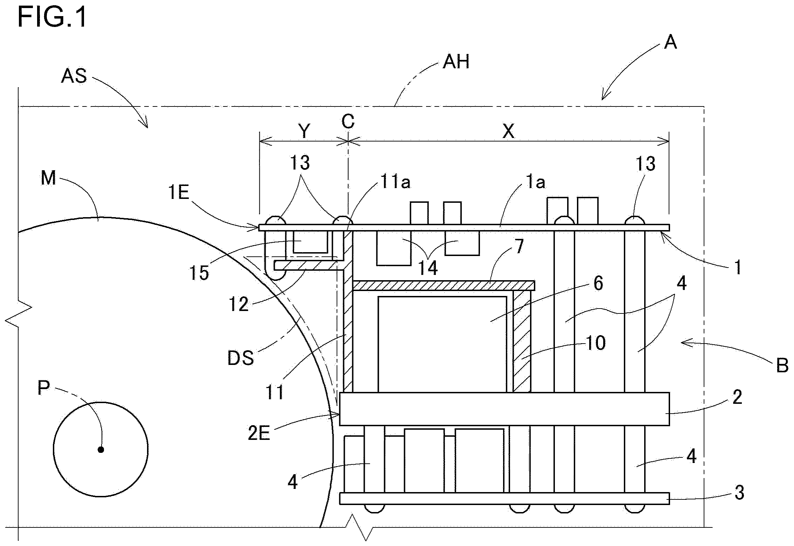

FIG. 1 shows a part of a cross section of a vehicle drive device A that transmits a drive force from a traveling motor M to wheels (not shown). The vehicle drive device A accommodates the traveling motor M, a gear mechanism (not shown) that reduces the drive force from the traveling motor M and that transmits the drive force to driving wheels (not shown), and a power conversion device B in an internal space AS of a housing AH.

Since the vehicle drive device A is provided in an upper-lower relationship shown in FIG. 1 in a vehicle, the upper-lower relationship will be described in the present embodiment in accordance with an upper-lower direction shown in FIG. 1.

The power conversion device B includes a charging OBC circuit 1 (an example of a power conversion circuit) that converts AC power from an AC power supply (basically, a commercial power supply) supplied from an outside of the vehicle into high-voltage DC power and that charges a battery (not shown), a DC-DC converter that steps down the DC power from the battery to a voltage to be used in an in-vehicle device and that outputs the stepped-down voltage, a voltage conversion unit that steps down the power from the battery to have a voltage of the commercial power supply and that outputs the stepped-down voltage as AC power, and the like. The OBC in the OBC circuit 1 described above is an abbreviation for an on board charger.

The power conversion device B is provided in a vehicle having a power configuration same as that of a plug-in hybrid electric vehicle (PHEV). Note that, the vehicle is not limited to the plug-in hybrid electric vehicle, and may be a hybrid electric vehicle (HEV), a battery electric vehicle (BEV), or a fuel cell electric vehicle (FCEV).

As shown in FIG. 1, the power conversion device B has a structure in which the OBC circuit 1 is disposed as the power conversion circuit at an upper portion, a cooling plate 2 is disposed in a middle in the upper-lower direction, a filter circuit substrate 3 is disposed at a lower end position, and these are connected by a plurality of connection frames 4. The power conversion device B includes the DC-DC converter, the voltage conversion unit, and the like described above, and is disposed close to a side portion of the traveling motor M in the internal space AS of the housing AH.

The filter circuit substrate 3 includes a plurality of electronic elements, a plurality of coil modules, a plurality of AC filters, and the like.

The cooling plate 2 functions to lower temperatures of both front and back surfaces of the cooling plate 2 by allowing a cooling fluid supplied from the outside to flow through an internal flow path. The cooling plate 2 can use, as the cooling fluid, cooling water such as a long-life coolant (LLC), insulating oil such as paraffinic oil, or a refrigerant such as a hydrofluorocarbon (HFC) or a hydrofluoroolefin (HFO), and in the present embodiment, cooling water such as a long-life coolant (LLC) containing ethylene glycol, propylene glycol, or the like is used.

The cooling plate 2 is connected to the lower filter circuit substrate 3 by the plurality of connection frames 4, and is configured to absorb heat from the filter circuit substrate 3 via the connection frames 4 by lowering temperatures of the connection frames 4. In addition, the electronic elements and the like mounted on the filter circuit substrate 3 are disposed in a state of being close to or in contact with a lower surface of the filter circuit substrate 3. Accordingly, the cooling plate 2 directly absorbs heat generated by the electronic elements and the like mounted on the filter circuit substrate 3, thereby preventing an increase in temperature.

A transformer 6 (power transformer) is disposed at a position close to an upper side of the cooling plate 2, and the cooling plate 2 includes a cooling wall 10 protruding upward on an opposite side of the traveling motor M with respect to the transformer 6. In addition, the cooling plate 2 includes a plate-shaped shield body 11 protruding upward on a side close to the traveling motor M. The shield body 11 is disposed between the traveling motor M and the power conversion device B and close to the OBC circuit 1.

Further, a shield plate 7 having both ends supported by the cooling wall 10 and the shield body 11 is disposed above the transformer 6. A metal material that blocks electromagnetic noise is used for the shield plate 7.

The cooling wall 10 and the shield body 11 do not have a structure that allows a cooling fluid to flow, and function to lower an ambient temperature by lowering the temperature through heat conduction. A metal material having a high thermal conductivity is used for the cooling wall 10 and the shield body 11, and a conductive resin material or a resin having a high thermal conductivity may also be used. When a metal material or a conductive resin material is used for the shield body 11, a configuration in which the metal material or the conductive resin material is electrically connected to a ground side of the power conversion device B is adopted.

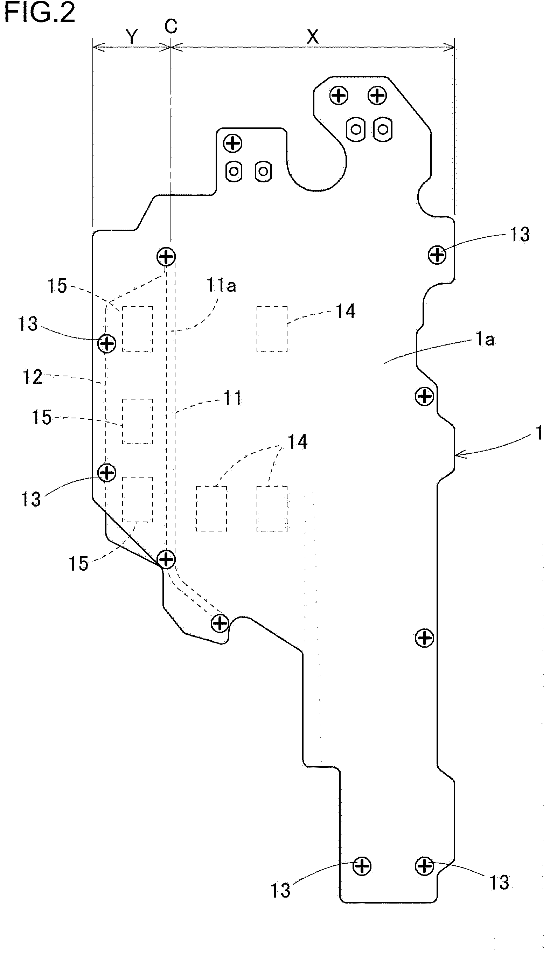

As shown in FIGS. 1 and 2, the OBC circuit 1 (power conversion circuit) includes, on a lower surface side, an electronic element that enables voltage conversion on an OBC substrate 1a (an example of a power conversion substrate) and an electronic element such as a capacitor. The OBC substrate 1a includes a plurality of high-voltage electronic components 14 and a plurality of low-voltage electronic components 15 as the electronic elements (a disposition and the like of these electronic elements will be described later).

Since the OBC substrate 1a (power conversion substrate) of the OBC circuit 1 is connected to the cooling plate 2 by the plurality of connection frames 4, heat can be dissipated via the connection frames 4. In particular, a standing portion 11a, which is an extending end at an upper end portion of the shield body 11, is connected to the OBC substrate 1a, and a parallel shield portion 12 integrally formed in a balcony shape at the upper end portion of the shield body 11 is disposed so as to extend in a direction of the traveling motor M in a posture along a lower surface of the OBC substrate 1a.

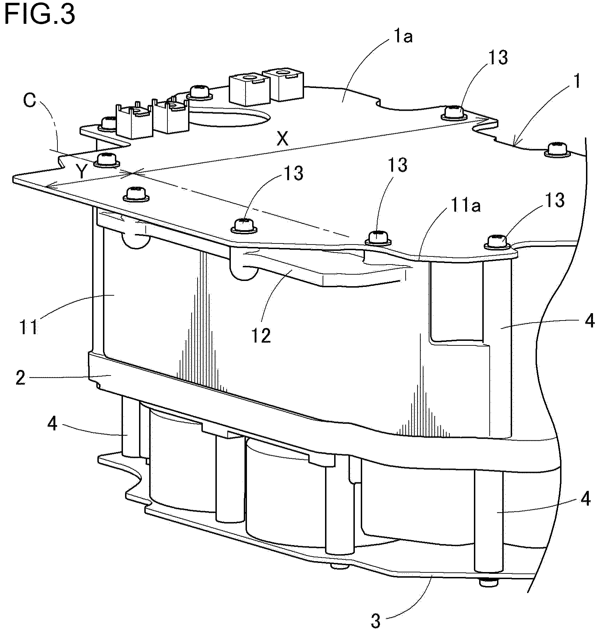

As shown in FIGS. 1 and 3, an end portion of the parallel shield portion 12 and the standing portion 11a at the upper end portion of the shield body 11 are connected to the OBC substrate 1a by a plurality of screws 13. With this configuration, heat from the electronic elements and the like of the OBC circuit 1 is transferred to the screws 13, the parallel shield portion 12, and the shield body 11, and cooling using the cooling plate 2 is can be implemented. Note that, a bolt or a rivet may be used to connect the end portion of the parallel shield portion 12 and the upper end portion of the shield body 11. When the parallel shield portion 12 and the shield body 11 are made of a metal, the parallel shield portion 12 and the shield body 11 can be fixed to a ground side of the OBC substrate 1a by soldering and brazing.

Note that, the entire shield body 11 functions as the standing portion 11a rising from a plate end portion 2E, and in the present embodiment, a structure having a base end side connected to the cooling plate 2 and branching from the cooling plate 2 and protruding upward is referred to as the shield body 11. In addition, the standing portion 11a is at the upper end portion of the shield body 11, and a position along a portion C (boundary in the present embodiment) between a high-voltage region X and a low-voltage region Y in a plan view is described as a connection portion.

### Countermeasure against Noise

A direction of a motor axis P around which a rotor of the traveling motor M rotates is set as shown in FIG. 1. The OBC substrate 1a, the cooling plate 2, and the filter circuit substrate 3 are disposed in a posture along the motor axis P, and the OBC substrate 1a, the cooling plate 2, and the filter circuit substrate 3 are disposed in a posture parallel to one another.

A substrate end portion 1E of the OBC substrate 1a (power conversion substrate) that approaches an outer periphery of the traveling motor M protrudes beyond the plate end portion 2E of the cooling plate 2 that approaches the outer periphery of the traveling motor M. Accordingly, a triangular dead space DS is formed between a lower side of the OBC substrate 1a and the outer periphery of the traveling motor M as viewed in the direction along the motor axis P. That is, the dead space DS is formed in an inverted triangular shape above the plate end portion 2E of the cooling plate 2 close to the traveling motor M and below a region of the OBC circuit 1 disposed above the traveling motor M.

As shown in FIG. 1, the OBC substrate 1a is disposed such that the substrate end portion 1E overlaps above the traveling motor M and the parallel shield portion 12 overlaps above the traveling motor M.

On the OBC substrate 1a of the OBC circuit 1, the high-voltage region X is disposed at a position farther from the traveling motor M, and the low-voltage region Y is disposed at a position close to the traveling motor M. The high-voltage electronic components 14 (a switching element, a capacitor, and the like for charging and discharging a high-voltage battery) for controlling a high voltage are disposed in the high-voltage region X, and the low-voltage electronic components 15 (a switching element, a capacitor, and the like for charging and discharging a low-voltage battery) for controlling a low voltage are disposed in the low-voltage region Y.

The OBC substrate 1a is disposed at a position where a part of an outer end side of the low-voltage region Y overlaps above the traveling motor M. Such a disposition is determined by a circuit design based on a positional relationship with another substrate, a size of the substrate, a reasonable disposition of the electronic elements, and the like.

The traveling motor M generates heat and generates electromagnetic noise during operation. Due to the OBC substrate 1a, the low-voltage electronic components 15 used in the low-voltage region Y are easily influenced by the temperature and the noise as compared with the high-voltage electronic components 14 used in the high-voltage region X. The low-voltage electronic components 15 may also be influenced by noise and heat generated in the high-voltage region X. The high-voltage electronic components 14 are not limited to the high-voltage electronic components 14 mounted on the OBC substrate 1a, and include the transformer 6 and the coil modules constituting the filter circuit substrate 3. Therefore, the high-voltage region X includes the high-voltage electronic components 14 mounted on the OBC substrate 1a, the transformer 6, the coil modules, and the like.

For this reason, as shown in FIG. 1, in a vertical region adjacent to the dead space DS, the shield body 11 is disposed at a position along the portion C between the high-voltage region X and the low-voltage region Y in the plan view, and the parallel shield portion 12 is disposed along a lower side of a portion of the OBC substrate 1a disposed above the traveling motor M inside the dead space DS.

As shown in FIGS. 1 and 3, the high-voltage region X and the low-voltage region Y are separated by disposing the standing portion 11a at the upper end portion of the shield body 11 at a position (boundary) of the OBC substrate 1a overlapping the portion C between the high-voltage region X and the low-voltage region Y in the plan view. The parallel shield portion 12 is disposed at a position farther downward from the lower surface of the OBC substrate 1a by a set distance. Accordingly, the parallel shield portion 12 covers lower sides of the low-voltage electronic components 15 on the OBC substrate 1a.

Due to such a positional relationship, the heat and the electromagnetic noise acting from the traveling motor M, and the heat and the electromagnetic noise acting from the high-voltage region X are blocked by the shield body 11 and the parallel shield portion 12, and malfunction of the low-voltage region Y can be prevented. Further, since the shield body 11 can block the heat and the electromagnetic noise acting from the traveling motor M, malfunction of the high-voltage region X is also prevented.

### Other Embodiments

In addition to the above embodiment, this disclosure may be implemented as follows (those having the same functions as the embodiment are denoted by the same reference numerals as in the embodiment).
(a) Not limited to being disposed on the OBC substrate 1a, the shield body 11 may be disposed in the portion C between the high-voltage electronic components 14 disposed in the high-voltage region X and the low-voltage electronic components 15 disposed in the low-voltage region Y in a power conversion circuit including the high-voltage region X including the high-voltage electronic components 14 and the low-voltage region Y including the low-voltage electronic components 15. As partially described in the embodiment, a material having at least one of a good electromagnetic shielding property and good thermal conductivity can be used for the shield body 11.
(b) In the embodiment, the shield body 11 is configured to allow the cooling fluid to flow therethrough. With such a configuration, the heat of the electronic components can be actively absorbed also in the shield body 11, and good heat dissipation can be implemented.
(c) The substrate constituting the power conversion circuit may have a configuration in which the electronic component is disposed on any one of an upper surface and a lower surface or both of the upper surface and the lower surface. That is, for example, the shield body 11 may be disposed on a substrate where the high-voltage region X including the high-voltage electronic components 14 and the low-voltage region Y including the low-voltage electronic components 15 are formed on an upper surface and the parallel shield portion 12 may be disposed along a lower surface of the substrate such that the standing portion 11a of the shield body 11 is close to the substrate from a lower side of the substrate toward the portion C therebetween.
   In addition, in another embodiment (c), it is also possible to form the high-voltage region X including the high-voltage electronic components 14 and the low-voltage region Y including the low-voltage electronic components 15 by disposing the electronic components on both surfaces of the substrate constituting the power conversion circuit, and to configure the standing portion 11a of the shield body 11 to be close to the portion C therebetween.
(d) The power conversion circuit may have a configuration in which a unit having the high-voltage region X including the high-voltage electronic components 14 and a unit having the low-voltage region Y including the low-voltage electronic components 15 are disposed in a positional relationship of being adjacent to each other.
   In the configuration of the embodiment (d), when there is a gap between the unit having the high-voltage region X and the unit having the low-voltage region Y, the shield body 11 can be disposed in the gap. Further, even when there is no gap, the shield body 11 can be disposed at a position close to the portion C.
(e) In the embodiment described above, the high-voltage electronic components 14 disposed in the high-voltage region X and the low-voltage electronic components 15 disposed in the low-voltage region Y are separated by disposing the standing portion 11a at the upper end portion of the shield body 11 at the position (boundary) of the OBC substrate 1a overlapping the portion C between the high-voltage region X and the low-voltage region Y in the plan view. Alternatively, the standing portion 11a at the upper end portion of the shield body 11 may be disposed slightly closer to a high-voltage region X side or a low-voltage region Y side than the boundary between the high-voltage region X and the low-voltage region Y in the plan view. In this case, the shield body 11 is also disposed between the high-voltage electronic components 14 in the high-voltage region X and the low-voltage electronic components 15 in the low-voltage region Y.

The principles, preferred embodiment and mode of operation of the present invention have been described in the foregoing specification. However, the invention which is intended to be protected is not to be construed as limited to the particular embodiments disclosed. Further, the embodiments described herein are to be regarded as illustrative rather than restrictive. Variations and changes may be made by others, and equivalents employed, without departing from the spirit of the present invention. Accordingly, it is expressly intended that all such variations, changes and equivalents which fall within the spirit and scope of the present invention as defined in the claims, be embraced thereby.

In the embodiments described above, the following configurations are conceivable.
(1) A power conversion device B includes a housing AH, a power conversion circuit (OBC circuit 1) accommodated in the housing AH and configured to convert power, and a cooling plate 2 accommodated in the housing AH and configured to cool the power conversion circuit (OBC circuit 1) by using a cooling fluid, the power conversion circuit (OBC circuit 1) includes a high-voltage electronic component 14 through which high-voltage power flows and a low-voltage electronic component 15 through which low-voltage power having a voltage lower than that of the high-voltage electronic component 14 flows, and a shield body 11 branching and protruding from the cooling plate 2 is disposed at a portion C between the high-voltage electronic component 14 and the low-voltage electronic component 15 in the power conversion circuit (OBC circuit 1).
   According to this, since the shield body 11 is disposed at the portion C between the high-voltage electronic component 14 and the low-voltage electronic component 15, a phenomenon in which heat and noise from the high-voltage electronic component 14 act on the low-voltage electronic component 15 is prevented.
(2) The power conversion device B according to (1) may further include a traveling motor M accommodated in the housing AH, and the shield body 11 may be disposed between the traveling motor M and the power conversion circuit (OBC circuit 1).
   According to this, noise or heat generated in the traveling motor M can be blocked by the shield body 11, and malfunction of the power conversion circuit (OBC circuit 1) due to the influence of the noise or the heat can be prevented.
(3) In the power conversion device B according to (1) or (2), a power conversion substrate (OBC substrate 1a) on which the power conversion circuit (OBC circuit 1) is mounted and the cooling plate 2 may be in a positional relationship of being parallel to each other along a motor axis P of the traveling motor M, a substrate end portion 1E of the power conversion substrate (OBC substrate 1a) on an outer peripheral side of the traveling motor M may protrude beyond a plate end portion 2E of the cooling plate 2 on the outer peripheral side of the traveling motor M, whereby a triangular dead space DS is formed between the power conversion substrate (OBC substrate 1a) and an outer periphery of the traveling motor M as viewed in a direction along the motor axis P, and the shield body 11 may include a standing portion 11a rising from the plate end portion 2E toward the power conversion substrate (OBC substrate 1a) at a position adjacent to the dead space DS.
   According to this, the triangular dead space DS as viewed in the direction along the motor axis P is formed between the power conversion substrate (OBC substrate 1a) and the outer periphery of the traveling motor M, and the shield body 11 adjacent to the dead space DS is disposed by effectively utilizing the dead space DS, so that it is possible to easily dispose the shield body 11 without difficulty, for example, even when a part of the shield body 11 has a shape protruding in a direction of the dead space DS.
(4) In the power conversion device B according to any one of (1) to (3), a parallel shield portion 12 in a posture along the power conversion substrate (OBC substrate 1a) toward the dead space DS may be formed at an extending end of the standing portion 11a of the shield body 11 on a side of the power conversion substrate (OBC substrate 1a).
   According to this, since the parallel shield portion 12 is formed in the posture along the power conversion substrate (OBC substrate 1a) at the extending end of the shield body 11, the parallel shield portion 12 can block noise and heat radiated from the traveling motor M toward the power conversion substrate (OBC substrate 1a) and prevent malfunction of the electronic components on the power conversion substrate (OBC substrate 1a). In addition, since the parallel shield portion 12 is formed toward the dead space DS, it is not necessary to perform a design change for securing a space for disposition.
(5) In the power conversion device B according to (1), the power conversion circuit (OBC circuit 1) may have a high-voltage region X in which the high-voltage electronic component 14 is disposed and a low-voltage region Y in which the low-voltage electronic component 15 is disposed.
   According to this, the power conversion circuit (OBC circuit 1) can be composed of the high-voltage region X in which the high-voltage electronic component 14 is disposed and the low-voltage region Y in which the low-voltage electronic component 15 is disposed.
(6) In the power conversion device B according to (5), the high-voltage region X may be disposed at a position farther from a traveling motor M accommodated in the housing AH than the low-voltage region Y, and the shield body 11 may include a standing portion 11a rising from a plate end portion 2E of the cooling plate 2 on an outer peripheral side of the traveling motor M toward a power conversion substrate (OBC substrate 1a) on which the power conversion circuit (OBC circuit 1) is mounted, and the standing portion 11a may be disposed at a position where the high-voltage region X and the low-voltage region Y are separated from each other.

According to this, noise and heat acting on the low-voltage region Y from the high-voltage region X can be reliably blocked by the standing portion 11a disposed at the position where the high-voltage region X and the low-voltage region Y are separated from each other.

### Industrial Applicability

This disclosure can be used for a power conversion device.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A power conversion device (B) comprising:
a housing (AH);
a power conversion circuit (1) accommodated in the housing and configured to convert power; and
a cooling plate (2) accommodated in the housing and configured to cool the power conversion circuit by using a cooling fluid, wherein
the power conversion circuit includes a high-voltage electronic component (14) through which high-voltage power flows and a low-voltage electronic component (15) through which low-voltage power having a voltage lower than a voltage of the high-voltage electronic component flows, and
a shield body (11) branching and protruding from the cooling plate is disposed between the high-voltage electronic component and the low-voltage electronic component in the power conversion circuit.

2. The power conversion device according to claim 1, further comprising:
a traveling motor (M) accommodated in the housing, wherein
the shield body is disposed between the traveling motor and the power conversion circuit.

3. The power conversion device according to claim 2, wherein
a power conversion substrate on which the power conversion circuit is mounted and the cooling plate are in a positional relationship of being parallel to each other along a motor axis (P) of the traveling motor,
a substrate end portion (1E) of the power conversion substrate on an outer peripheral side of the traveling motor protrudes beyond a plate end portion (2E) of the cooling plate on the outer peripheral side of the traveling motor, whereby a triangular dead space (DS) is formed between the power conversion substrate and an outer periphery of the traveling motor as viewed in a direction along the motor axis, and
the shield body includes a standing portion (11a) rising from the plate end portion toward the power conversion substrate at a position adjacent to the dead space.

4. The power conversion device according to claim 3, wherein
a parallel shield portion in a posture along the power conversion substrate toward the dead space is formed at an extending end of the standing portion of the shield body 11 on a side of the power conversion substrate.

5. The power conversion device according to any one of claims 1 to 4, wherein
the power conversion circuit has a high-voltage region (X) in which the high-voltage electronic component is disposed and a low-voltage region (Y) in which the low-voltage electronic component is disposed.

6. The power conversion device according to claim 5, wherein
the high-voltage region is disposed at a position farther from a traveling motor accommodated in the housing than the low-voltage region, and
the shield body includes a standing portion rising from a plate end portion of the cooling plate on an outer peripheral side of the traveling motor toward a power conversion substrate on which the power conversion circuit is mounted, and the standing portion is disposed at a position where the high-voltage region and the low-voltage region are separated from each other.

7. The power conversion device according to any one of claims 1 to 6, wherein
the shield body is configured to allow the cooling fluid to flow.

8. The power conversion device according to claim 3 or 4, wherein
an upper end of the shield body is connected to the power conversion substrate.
